# EUROPÄISCHE PATENTSCHRIFT

(11) **EP 4 116 064 B1**
(45) Veröffentlichungstag und Bekanntmachung des Hinweises auf die Patenterteilung: **25.12.2024**
(21) Anmeldenummer: 21183874.3
(22) Anmeldetag: 06.07.2021
(51) Int. Cl.: B29C 64/124, B29C 64/386, B33Y 10/00, B33Y 50/00, G06N 3/08, G06N 3/09

(54) **OPTIMIERUNG DER DOSISVERTEILUNG IM 3D-DRUCK MITTELS EINES NEURONALEN NETZES**
OPTIMIZATION OF THE DOSE DISTRIBUTION IN 3D PRINTING USING A NEURAL NETWORK
OPTIMISATION DE LA DISTRIBUTION DE DOSE EN IMPRESSION 3D AU MOYEN D'UN RÉSEAU DE NEURONES

(43) Veröffentlichungstag der Anmeldung: 11.01.2023
(73) Patentinhaber: DENTSPLY SIRONA Inc., York, PA 17401 (US); Sirona Dental Systems GmbH, 64625 Bensheim (DE)
(72) Erfinder: Stahl, Christian, 64625 Bensheim (DE)
(74) Vertreter: Özer, Alpdeniz

(56) Entgegenhaltungen:
- WO-A1-2018/217903
- WO-A1-2020/070136
- WO-A1-2020/198404
- US-A1- 2020 103 857
- US-B2- 10 647 055

## Beschreibung

### TECHNISCHES GEBIET DER ERFINDUNG

Die vorliegende Erfindung bezieht sich auf additive Herstellungsverfahren, insbesondere 3D-Druckverfahren, von Bauteilen und 3D Drucker.

### HINTERGRUND DER ERFINDUNG

Beim 3D-Druck wird in bestimmten Verfahren wie z.B. SLA oder DLP ein Bauteil erzeugt, in dem photoreaktives Harz schichtweise ausgehärtet wird. Dabei wird in gängigen Varianten der Verfahren die Belichtung von unten durch einen lichtdurchlässigen transparenten Boden in eine Wanne hinein vollzogen.

Im 3D-Druck (hier: DLP-Verfahren) wird das photoreaktive Harz durch räumlich selektive UV-Bestrahlung schichtweise verfestigt. Der lokale Vernetzungsgrad des Polymermaterials (= photoreaktives Harz) im Grünling (=Bauteil direkt nach dem Druck) ist bestimmt durch die räumliche Verteilung der Dosis des absorbierten UV-Lichts im Bauteil, nämlich die Dosisverteilung.

Der lokale Vernetzungsgrad des Polymermaterials im Grünling bestimmt sowohl die Genauigkeit des 3D Druckes als auch mechanischen Eigenschaften des gedruckten Bauteils. Zu den Effekten, die Einfluss auf die Genauigkeit des Bauteils haben, zählen u.a. Durchbelichtung ("z-Bleeding") sowie Verzug durch Polymerisationsschrumpf (auch beim Nachbelichten im Anschluss an den Druck). Die mechanischen Eigenschaften des gedruckten Bauteils, die durch den lokalen Vernetzungsgrad im Grünling beeinflusst werden können, sind z.B. Biegefestigkeit, Bruchdehnung, Härte. Die Optimierung der Dosisverteilung bzw. das Erreichen von Mindestanforderungen in Bezug auf Genauigkeit und mechanische Kennwerte durch Variation der Belichtungsstrategie erfolgt klassischerweise durch Druckversuche, in denen die Effekte einzelner Parameteränderungen verfolgt werden. Die Dosisverteilung selbst ist dabei i.A. keine Observable, es werden Konsequenzen aus der vorliegenden Dosisverteilung beobachtet.

Es ist mithilfe von Simulationen recht einfach möglich, aus vorgegebenen Belichtungsdaten eines Druckauftrages (=Schnittbilder, Zustellungen der Bauplattform, Leistungsdichten und Belichtungszeiten, also die elementaren Prozessdaten, die der 3D-Drucker verarbeitet) die Dosisverteilung im Bauteil zu berechnen. Die Rechnung in die andere Richtung, also wie man eine gewünschte Dosisverteilung durch die Wahl der Belichtungsdaten erreicht, ist hochgradig komplex.

WO2020198404A1 offenbart eine iterative Berechnung einer Belichtungsstrategie die eine vorgegebene gewünschte Dosisverteilung abbildet beim 3D-druck von photohärtbare Kolloiden.

### OFFENBARUNG DER ERFINDUNG

Aktuell ist den Erfindern kein Stand der Technik bekannt mit dem eine gewünschte Dosisverteilung durch die Wahl der Belichtungsdaten erreicht werden kann. Für Probleme dieser Klasse (Rechnung in eine Richtung trivial, in die andere hochkomplex) bietet sich die Optimierung mittels neuronaler Netze an, weil durch die Rechnungen/Simulationen "in der einfachen Richtung" leicht Trainingsdaten für ein neuronales Netz erzeugt werden können, welche das Problem "in der schwierigen Richtung" lösen können.

Ziel der vorliegenden Erfindung ist die Bereitstellung eines Verfahrens zur Berechnung einer Belichtungsstrategie zum Erreichen einer gewünschten Dosisverteilung mithilfe eines neuronalen Netzes durch Optimierung der Dosisverteilung.

Ein weiteres Ziel der vorliegenden Erfindung ist die Bereitstellung eines 3D Drucksystems, das das Bauteil nach den errechneten Belichtungsdaten druckt.

Diese Ziele werden durch das Verfahren nach Anspruch 1 und das 3D Drucksystem nach Anspruch 8 erreicht. Die Gegenstände der abhängigen Ansprüche beziehen sich auf Weiterentwicklungen sowie bevorzugte Ausführungsformen.

Eine vorteilhafte Wirkung der Erfindung ist, dass die herkömmliche Berechnung der Belichtungsstrategie durch Druckversuche durch das erfindungsgemäße Verfahren zumindest teilweise ersetzt bzw. unterstützt werden kann. Dadurch wird es ermöglicht, dass das Druckverfahren bzw. die Berechnung der Belichtungsstrategie beschleunigt werden kann und bessere Belichtungsstrategien gefunden werden können. Mit verbesserten Belichtungsstrategien können bessere Druckergebnisse in Bezug auf Druckgeschwindigkeit, Genauigkeit und mechanischen Eigenschaften erzielt werden.

Das neuronale Netz bekommt vorzugsweise als Eingabe die gewünschte Dosisverteilung, die aus der Prozessentwicklung auf Basis der bisherigen Erfahrung aus Druckversuchen bestimmt wird.

Das neuronale Netz errechnet vorzugsweise die Schichtzerlegung des zu druckenden Bauteils, wenn zusätzlich die Triangulation des zu druckenden Bauteils an das neuronale Netz eingegeben wird. Anstelle von Triangulationen können auch andere bekannte Repräsentationen verwendet werden.

Das neuronale Netz kann vorzugsweise durch eine Maßzahl, z.B. einen Score, optimiert werden, die die Abweichung zwischen der gewünschten Dosisverteilung und der Dosisverteilung, die sich aus den vom neuronalen Netz vorgeschlagenen Belichtungsdaten ergibt, darstellt. Die Druckzeit bzw. Druckgeschwindigkeit, die mechanischen Kennwerte und/oder die Maßhaltigkeit, die sich aus den Belichtungsdaten ergibt, kann ebenfalls vorzugsweise als Kriterium in die Maßzahl einfließen. Ergebnisse können in Druckversuchen validiert werden. D.h. die durch Optimierung mit dem neuronalen Netz bestimmten Belichtungsstrategien können im Druckversuch direkt angewendet und bewertet werden. Bewertungskriterien können dann Observablen wie z.B. Druckgeschwindigkeit, Maßhaltigkeit und mechanische Kennwerte sein.

Eine vorteilhafte Wirkung der Erfindung ist, dass durch das neuronale Netz auf Belichtungsstrategien trainiert werden kann. Somit kann sowohl der Betrieb des 3D Druckers als auch ein bestimmter 3D-Druck-Job hinsichtlich Druckgeschwindigkeit, Genauigkeit und mechanischen Eigenschaften optimal durchgeführt werden.

Das neuronale Netz kann durch eine Hardware oder Software implementiert werden. Das neuronale Netz kann als Hardware oder Software ein integraler Bestandteil des 3D Drucksystems sein. Alternativ kann das neuronale Netz separat vom 3D Drucksystem bereitgestellt werden und über eine Kommunikationsschnittstelle die berechneten Belichtungsdaten an den 3D Drucker liefern. Das neuronale Netz kann z.B. in der Cloud betrieben werden.

Das neuronale Netz kann vorab mit den Trainingsdaten, die von einem 3D Drucksystem stammen, trainiert werden. Die Trainingsdaten können über eine Cloud zum Trainieren an das Netzwerk angeschlossenen neuronalen Netzen zur Verfügung gestellt werden.

In einer bevorzugten Ausführungsform werden Belichtungsdaten der aktuellen Schicht unter Berücksichtigung der vorher belichteten Schichten bestimmt.

### KURZBESCHREIBUNG DER ZEICHNUNG

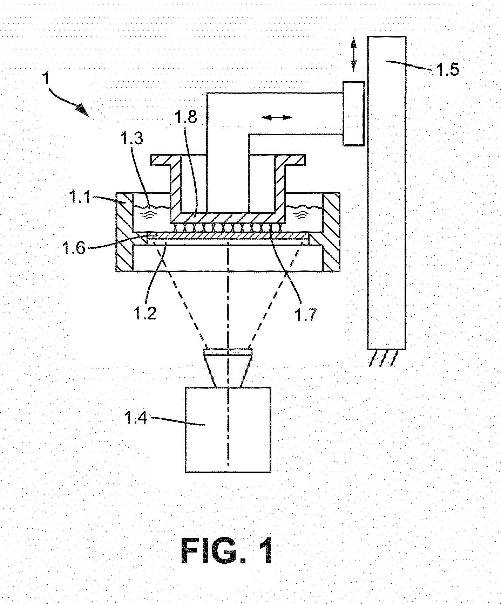

In der nachfolgenden Beschreibung wird die vorliegende Erfindung anhand von Ausführungsbeispielen unter Bezugnahme auf die Zeichnung näher erläutert, wobei Abb. 1 - zeigt eine schematische Teilansicht eines 3D Druckers nach einer Ausführungsform der Erfindung.

Die in der Zeichnung gezeigten Referenznummern bezeichnen die unten aufgeführten Elemente, auf die in der nachfolgenden Beschreibung der beispielhaften Ausführungsformen Bezug genommen wird.
- 1: 3D Drucker
- 1.1: Wanne
- 1.2: Transparenter Boden
- 1.3: Photoreaktives Harz
- 1.4: Projektor
- 1.5: Transportapparat
- 1.6: Folie
- 1.7: Schicht
- 1.8: Bauplattform

Das erfindungsgemäße Verfahren dient zum Drucken eines Bauteils mittels eines 3D Drucksystems, das einen 3D Drucker (1) wie in Abb. 1 dargestellt beinhaltet. Zuerst wird eine gewünschte Dosisverteilung des zu druckenden Bauteils bestimmt. Diese kann z.B. aus der Prozessentwicklung auf Basis der bisherigen Erfahrungen aus Druckversuchen erfolgen. In einem Eingabeschritt wird die gewünschte Dosisverteilung des zu druckenden Bauteils an einem neuronalen Netz mittels einer CAD/CAM Software eingegeben. Das neuronale Netz errechnet eine Belichtungsstrategie inklusive Belichtungsdaten, die die vorgegebene gewünschte Dosisverteilung für das Bauteil optimal abbilden. Das Trainieren und Optimieren des neuronalen Netztes wird später in der nachfolgenden Beschreibung detaillierter erklärt. Anschließend werden die errechneten Belichtungsdaten dem 3D Drucksystem bzw. dem 3D Drucker (1) bereitgestellt. Der 3D Drucker (1) druckt das Bauteil mit den errechneten Belichtungsdaten.

Wie in Abb. 1 gezeigt, umfasst der 3D Drucker (1) eine Wanne (1.1) mit einem mindestens teilweise transparenten Boden (1.2) zur Aufnahme von flüssigem photoreaktivem Harz (1.3) zur Herstellung eines festen Bauteils; eine Bauplattform (1.8) zum schichtweisen Herausziehen des Bauteils aus der Wanne (1.1); einen Projektor (1.4) zum Projizieren der Schichtgeometrie auf den transparenten Boden (1.2); einen Transportapparat (1.5) zum mindestens Abwärts- und Aufwärtsbewegen der Bauplattform (1.8) in der Wanne (1.1); und eine Steuerungsvorrichtung zum Steuern des Projektors (1.4) und des Transportapparats (1.5). Die Steuerungsvorrichtung veranlasst das Drucken des Bauteils nach den berechneten Belichtungsdaten.

Das neuronale Netz wird vorzugsweise als Software implementiert. Die Software wird auf einem computerlesbaren Speichermedium bereitgestellt. Die Software hat einen computerlesbaren Code, der auf einer Recheneinheit bzw. Rechner ausgeführt werden kann. Die Recheneinheit bzw. der Rechner ist vorzugsweise Bestandteil des 3D Drucksystems, und ist mit dem 3D Drucker verbunden bzw. verbindbar. Alternativ kann die Software des neuronalen Netzes separat vom 3D Drucksystem zur Verfügung gestellt werden. Diese kann lokal auf einem Rechner oder der Cloud ausgeführt werden. Das 3D Drucksystem kann an den Rechner oder die Cloud über eine Kommunikationsschnittstelle angeschlossen werden. Alternativ kann das neuronale Netz als Hardware in einer Vorrichtung implementiert werden. Die Vorrichtung ist vorzugsweise Bestandteil des 3D Drucksystems. Die Vorrichtung kann aber auch separat vom 3D Drucksystems zur Verfügung gestellt werden. Das 3D Drucksystem kann mit der Hardware des neuronalen Netzes über die Kommunikationsschnittstelle verbunden werden. Die Eingabe in das neuronale Netz und die Übermittlung der Belichtungsdaten können über die Kommunikationsschnittstelle erfolgen. Die Kommunikationsschnittstelle kann eine Kabel- oder kabellose Verbindung aufweisen. Das 3D Drucksystem hat vorzugsweise eine CAD/CAM Software für die Erstellung von Druckaufträgen. Diese kann auch auf einem separaten Rechner betrieben werden. Die herkömmliche Berechnung der Belichtungsstrategie kann durch das neuronale Netz gänzlich oder zumindest teilweise ersetzt bzw. unterstützt werden . In einer weiteren bevorzugten Ausführungsform kann auch die Schichtzerlegung dem neuronalen Netz überlassen werden. Eingangsschicht des neuronalen Netzes wäre dann z.B. die Triangulation des zu druckenden Bauteils. Zusätzlich kann das neuronale Netz die Schichtzerlegung des zu druckenden Bauteils vorzugsweise errechnen, wenn die Triangulation des zu druckenden Bauteils in das neuronale Netz eingegeben wird.

### Trainingsdaten und das Trainieren des Neuronalen Netzes

Es ist mithilfe von Rechnungen/Simulationen recht einfach möglich, aus vorgegebenen Belichtungsdaten eines Druckauftrages (=Schnittbilder, Zustellungen der Bauplattform, Leistungsdichten und Belichtungszeiten, also die elementaren Prozessdaten, die der 3D-Drucker (1) verarbeitet) die Dosisverteilung im Bauteil zu berechnen. Diese Rechnungen/Simulationen können leicht als Trainingsdaten für ein neuronales Netz erzeugt und benutzt werden. In einer Ausführungsform wird das neuronale Netz mittels Trainingsdaten, die aus Simulationen stammen trainiert, wobei in jeder Simulation für vorgegebene Belichtungsdaten eines Druckauftrages inklusive der vom 3D-Drucker (1) zu verarbeitenden Prozessdaten die Dosisverteilung im Bauteil berechnet wurde. Diese Trainingsdaten können vom selben 3D Drucker (1) oder anderen 3D Druckern stammen. Trainingsdaten können über eine Cloud/Speicher zum Trainieren an das Netzwerk angeschlossene neuronale Netze zur Verfügung gestellt werden.

Ergebnisse können in Druckversuchen validiert werden. D.h. die durch Optimierung mit dem neuronalen Netz bestimmten Belichtungsstrategien können im Druckversuch direkt angewendet und bewertet werden. Bewertungskriterien können dann Observablen wie z.B. Druckgeschwindigkeit, Maßhaltigkeit und mechanische Kennwerte sein. Die Bewertung eines Outputs von der Ausgangsschicht des neuronalen Netzes erfolgt z.B. indem aus dem Output eine Simulation des Druckergebnisses (incl. Geometrie und Dosisverteilung) erzeugt wird. Dieses Simulationsergebnis wird mit der Sollgeometrie und der gewünschten bzw. bevorzugten Dosisverteilung verglichen. Aus Abweichungen wird eine Maßzahl (Score) berechnet. Als Maßzahl für das Training kann z.B. die Abweichung zwischen gewünschter Dosisverteilung und der Dosisverteilung, die sich aus den vom neuronalen Netz vorgeschlagenen Belichtungsdaten ergibt, zur Optimierung dienen. In weiteren bevorzugten Ausführungsformen können eine oder mehrerer der folgenden Kenngrößen: Druckzeit bzw. Druckgeschwindigkeit des Druckauftrages, die mechanischen Kennwerte und die Maßhaltigkeit des Bauteils, die sich aus den vom neuronalen Netzes vorgeschlagenen Belichtungsdaten ergibt, ebenfalls als Kriterium in die Maßzahl zur Optimierung einfließen.

## Patentansprüche

1. Verfahren zum Drucken eines Bauteils mittels eines 3D Druckers (1), wobei das Verfahren folgende Schritte umfasst:
Eingeben einer gewünschten Dosisverteilung des zu druckenden Bauteils an einem neuronalen Netz mittels einer CAD/CAM Software, wobei die Dosisverteilung ist definiert als die räumliche Verteilung der Dosis des absorbierten UV-Lichts im Bauteil;
Berechnung der Belichtungsstrategie inklusive der Belichtungsdaten mittels des neuronalen Netzes, die die vorgegebene gewünschte Dosisverteilung für das Bauteil optimal abbildet;
Drucken des Bauteils mit den berechneten Belichtungsdaten,
wobei das neuronale Netz mittels Trainingsdaten, die aus Simulationen stammen, trainiert wird, wobei in jeder Simulation für vorgegebene Belichtungsdaten eines Druckauftrages, welche die vom 3D Drucker zu verarbeitenden Prozessdaten beinhalten, die Dosisverteilung im Bauteil berechnet wurde.

2. Verfahren nach Anspruch 1, **gekennzeichnet dadurch, dass** beim Trainieren des neuronalen Netzes die Abweichung zwischen der gewünschten Dosisverteilung und der Dosisverteilung, die sich aus den vom neuronalen Netz vorgeschlagenen Belichtungsdaten ergibt, als Maßzahl zur Optimierung dient.

3. Verfahren nach Anspruch 2, **gekennzeichnet dadurch, dass** beim Trainieren des neuronalen Netzes die Druckzeit bzw. Druckgeschwindigkeit, die sich aus den vom neuronalen Netz vorgeschlagenen Belichtungsdaten ergibt, ebenfalls als Kriterium in die Maßzahl zur Optimierung einfließt.

4. Verfahren nach Anspruch 2 oder 3, **gekennzeichnet dadurch, dass** beim Trainieren des neuronalen Netzes die mechanischen Kennwerte, die sich aus den vom neuronalen Netz vorgeschlagenen Belichtungsdaten ergibt, ebenfalls als Kriterium in die Maßzahl zur Optimierung einfließen.

5. Verfahren nach einem der Ansprüche 2 bis 4, **gekennzeichnet dadurch, dass** beim Trainieren des neuronalen Netzes die Maßhaltigkeit, die sich aus den vom neuronalen Netz vorgeschlagenen Belichtungsdaten ergibt, ebenfalls als Kriterium in die Maßzahl zur Optimierung einfließt.

6. Verfahren nach einem der Ansprüche 1 bis 5, **gekennzeichnet dadurch, dass** das neuronale Netz durch eine Software implementiert wird, wobei die Software computerlesbaren Code aufweist, der wenn dieser auf einer mit einem 3D Drucker (1) verbundenen Recheneinheit ausgeführt wird, den 3D Drucker (1) veranlasst, das Bauteil nach den errechneten Belichtungsdaten zu drucken.

7. Speichermedium umfassend computerlesbarer Code, welche bei Ausführung auf einer mit einem 3D Drucker verbundenen Recheneinheit, den 3D Drucker veranlassen, das Verfahren nach einem der Ansprüche 1-6 auszuführen.

8. 3D Drucksystem, das einen 3D Drucker (1) aufweist, wobei der 3D Drucker (1)
eine Wanne (1.1) mit einem mindestens teilweise transparenten Boden (1.2) zur Aufnahme von flüssigem photoreaktivem Harz (1.3) zur Herstellung eines festen Bauteils;
eine Bauplattform (1.8) zum schichtweisen Herausziehen des Bauteils aus der Wanne (1.1);
einen Projektor (1.4) zum Projizieren der Schichtgeometrie auf den transparenten Boden (1.2);
einen Transportapparat (1.5) zum mindestens Abwärts- und Aufwärtsbewegen der Bauplattform (1.8) in der Wanne (1.1); und
eine Steuerungsvorrichtung zum Steuern des Projektors (1.4) und des Transportapparats (1.5) umfasst,
**gekennzeichnet dadurch, dass** das 3D Drucksystem das neuronale Netz nach einem der Ansprüche 1 bis 6 aufweist;
wobei die Steuerungsvorrichtung das Drucken des Bauteils nach dem Verfahren nach einem der Ansprüche 1-6 veranlasst.

## Claims

1. A method for printing a component by means of a 3D printer (1), wherein the method comprises the following steps:
entering a desired dose distribution of the component to be printed on a neuronal network by means of CAD/CAM software, wherein the dose distribution is defined as the spatial distribution of the dose of absorbed UV light in the component;
calculation of the exposure strategy including the exposure data using the neuronal network, which optimally maps the specified desired dose distribution for the component;
printing the component with the calculated exposure data,
wherein the neuronal network is trained using training data obtained from simulations, wherein the dose distribution in the component was calculated in each simulation for given exposure data of a print job containing the process data to be processed by the 3D printer.

2. The method according to claim 1, **characterized in that** when training the neuronal network, the deviation between the desired dose distribution and the dose distribution resulting from the exposure data suggested by the neuronal network serves as a statistic for optimization.

3. The method according to claim 2, **characterized in that**, when training the neuronal network, the printing time or printing speed resulting from the exposure data suggested by the neuronal network is also included as a criterion in the statistic for optimization.

4. The method according to claim 2 or 3, **characterized in that**, when training the neuronal network, the mechanical characteristic values resulting from the exposure data suggested by the neuronal network are also included as a criterion in the statistic for optimization.

5. The method according to any one of claims 2 to 4, **characterized in that**, when training the neuronal network, the dimensional accuracy resulting from the exposure data suggested by the neuronal network is also included as a criterion in the statistic for optimization.

6. The method according to any one of claims 1 to 5, **characterized in that** the neuronal network is implemented by software, wherein the software comprises computer-readable code which, when executed on a computing unit connected to a 3D printer (1), causes the 3D printer (1) to print the component according to the calculated exposure data.

7. A storage medium comprising computer-readable code which, when executed on a computing unit connected to a 3D printer, causes the 3D printer to execute the method according to any one of claims 1-6.

8. A 3D printing system having a 3D printer (1), wherein the 3D printer (1) comprises
a trough (1.1) with an at least partially transparent bottom (1.2) for holding liquid photoreactive resin (1.3) to produce a solid component;
a build platform (1.8) for extracting the component from the trough (1.1) layer by layer;
a projector (1.4) to project the layer geometry onto the transparent bottom (1.2);
a transport apparatus (1.5) to move the build platform (1.8) at least downwards and upwards in the trough (1.1); and
a control device to control the projector (1.4) and the transport apparatus (1.5),
**characterized in that** the 3D printing system
has the neuronal network according to any one of claims 1 to 6;
wherein the control device causes the printing of the component according to the method according to any one of claims 1-6.

## Revendications

1. Procédé d'impression d'un composant au moyen d'une imprimante 3D (1), dans lequel le procédé comprend les étapes suivantes :
la saisie d'une répartition de dosage souhaitée du composant à imprimer au niveau d'un réseau neuronal au moyen d'un logiciel CAD/CAM, dans lequel la répartition de dosage est définie comme la répartition spatiale de la dose de la lumière UV absorbée dans le composant ;
le calcul de la stratégie d'exposition, y compris les données d'exposition, au moyen du réseau neuronal, reproduisant de manière optimale la répartition de dosage souhaitée prédéfinie pour le composant ;
l'impression du composant avec les données d'exposition calculées,
dans lequel le réseau neuronal est entraîné au moyen de données d'entraînement provenant de simulations, dans lequel, dans chaque simulation, la répartition de dosage dans le composant a été calculée pour des données d'exposition prédéterminées d'une tâche d'impression, lesquelles contiennent les données de processus à traiter par l'imprimante 3D.

2. Procédé selon la revendication 1, **caractérisé en ce que**, lors de l'entraînement du réseau neuronal, l'écart entre la répartition de dosage souhaitée et la répartition de dosage résultant des données d'exposition proposées par le réseau neuronal sert de mesure pour l'optimisation.

3. Procédé selon la revendication 2, **caractérisé en ce que**, lors de l'entraînement du réseau neuronal, la durée d'impression, respectivement la vitesse d'impression résultant des données d'exposition proposées par le réseau neuronal est également intégrée comme critère dans la mesure pour l'optimisation.

4. Procédé selon la revendication 2 ou 3, **caractérisé en ce que**, lors de l'entraînement du réseau neuronal, les caractéristiques mécaniques résultant des données d'exposition proposées par le réseau neuronal sont également intégrées comme critère dans la mesure pour l'optimisation.

5. Procédé selon l'une quelconque des revendications 2 à 4, **caractérisé en ce que**, lors de l'entraînement du réseau neuronal, la conformité dimensionnelle résultant des données d'exposition proposées par le réseau neuronal est également intégrée comme critère dans la mesure pour l'optimisation.

6. Procédé selon l'une quelconque des revendications 1 à 5, **caractérisé en ce que** le réseau neuronal est mis en oeuvre par un logiciel, dans lequel le logiciel comprend un code lisible par ordinateur qui, lorsqu'il est exécuté sur une unité de calcul connectée à une imprimante 3D (1), amène l'imprimante 3D (1) à imprimer le composant selon les données d'exposition calculées.

7. Support de stockage comprenant un code lisible par ordinateur qui, lorsqu'il est exécuté sur une unité de calcul connectée à une imprimante 3D, amène l'imprimante 3D à exécuter le procédé selon l'une quelconque des revendications 1 à 6.

8. Système d'impression 3D présentant une imprimante 3D (1), dans lequel l'imprimante 3D (1) comprend
une cuve (1.1) présentant un fond (1.2) au moins partiellement transparent, pour la réception d'une résine photoréactive liquide (1.3) pour la fabrication d'un composant solide ;
une plate-forme de construction (1.8) pour l'extraction couche par couche du composant hors de la cuve (1.1) ;
un projecteur (1.4) pour la projection de la géométrie en couches sur le fond (1.2) transparent ;
un appareil de transport (1.5) pour au moins le déplacement vers le bas et vers le haut de la plate-forme de construction (1.8) dans la cuve (1.1) ; et
un dispositif de commande pour la commande du projecteur (1.4) et de l'appareil de transport (1.5),
**caractérisé en ce que** le système d'impression 3D
présente le réseau neuronal selon l'une quelconque des revendications 1 à 6;
dans lequel le dispositif de commande amène l'impression du composant selon le procédé selon l'une quelconque des revendications 1 à 6.
